Europäisches Patentamt

European Patent Office

Office européen des brevets

(19)

(11) Veröffentlichungsnummer: **0 266 632 B1**

## (12) EUROPÄISCHE PATENTSCHRIFT

(45) Veröffentlichungstag der Patentschrift: **12.06.91**

(21) Anmeldenummer: **87115397.9**

(22) Anmeldetag: **21.10.87**

(51) Int. Cl.⁵: **G09F 9/30**, G01R 13/40, G01D 7/02

(54) **Display zur Darstellung von Messwerten mit 7-Segment-Anzeigen.**

(30) Priorität: **05.11.86 DE 3637584**

(43) Veröffentlichungstag der Anmeldung:
**11.05.88 Patentblatt 88/19**

(45) Bekanntmachung des Hinweises auf die
Patenterteilung:
**12.06.91 Patentblatt 91/24**

(84) Benannte Vertragsstaaten:
**DE FR IT**

(56) Entgegenhaltungen:
**DE-A- 2 651 542**
**FR-A- 2 400 240**
**FR-A- 2 401 404**

(73) Patentinhaber: **Asea Brown Boveri Aktienge-**
**sellschaft**
**Kallstadter Strasse 1**
**W-6800 Mannheim-Käfertal(DE)**

(72) Erfinder: **Hänel, Horst, Dipl.-Ing.**
**Schuckertplatz 12**
**W-8500 Nürnberg 40(DE)**
Erfinder: **Heberlein, Reinhard, Dipl.-Ing. FH**
**Am Neubruch 18**
**W-8501 Behringersdorf(DE)**
Erfinder: **Wagner, Armin, Dipl.-Ing. FH**
**Kölner Strasse 24**
**W-8500 Nürnberg 90(DE)**

(74) Vertreter: **Rupprecht, Klaus, Dipl.-Ing. et al**
**c/o BBC Brown Boveri Aktiengesellschaft**
**ZPT Postfach 100351 Kallstadter Strasse 1**
**W-6800 Mannheim 1(DE)**

## Beschreibung

Die Erfindung betrifft ein Display der im Oberbegriff des Anspruchs 1 genannten Art.

Bei der Darstellung von Meßwerten hat sich, was die Genauigkeit betrifft, die Ziffernanzeige durchgesetzt. Zur schnellen Orientierung über Änderungen und Tendenzen eines Meßwertes bleibt jedoch die Analoganzeige überlegen. Für viele Anwendungen ist es zweckmäßig, die Vorteile beider Anzeigen zu nutzen, so daß entsprechende Meßgeräte mit einer kombinierten Anzeige versehen werden. Entscheidend ist es dabei , den Aufwand möglichst gering zu halten. Bei einem Meßgerät, das zur Ziffernanzeige ohnehin digital arbeiten muß, bietet es sich an, auch die Analoganzeige mit digitalen Mitteln zu realisieren.

Es ist bekannt bei Meßgeräten, insbesondere auch bei Reglern, neben einer Ziffernanzeige eine sogenannte Balkenanzeige anzuordnen, die digital angesteuert wird und somit eine quasi analoge Anzeige bildet. Anstelle eines Balkens wird ggf. auch nur ein einzelnes Segment quasi als Zeiger angesteuert, durch dessen Lage der Meßwert gekennzeichnet wird (vgl. z.B. FR-A-2401404 und FR-A-2400240).

Die Anzeige von Ziffern erfolgt überlicherweise mit einer sogenannten 7-Segment-Anzeige. Um das Display möglichst einfach gestalten zu können, und mit relativ einfachen Steuermitteln auszukommen, hat man Regler entwickelt, bei denen die Ansteuerung der einzelnen Segmente der die Ziffern bildenden 7-Segment-Anzeigen umschaltbar sind. Die Umschaltung erfolgt derart, daß jeweils die drei waagrechten Segmente einer 7-Segment-Anzeige in ihrer Anordnung als Skala aufgefaßt werden können, bei der dann jeweils ein Segment angesteuert wird. Es erfolgt also eine quasi analoge Anzeige, mit der es möglich ist, z.B. Regelabweichungen sichtbar zu machen.

Bei komfortableren Meßgeräten kann eine Analoganzeige mit nur drei Anzeigepositionen nicht befriedigen. Bei Reglern ist es außerdem erwünscht, zur gleichen Zeit den Sollwert und den Istwert anzeigen zu können, wozu zwei Ziffernanzeigen benötigt werden.

Aufgabe der Erfindung ist es, ein Display zu schaffen, das es ermöglicht, zwei Meßwerte zur gleichen Zeit anzuzeigen und im Wechsel hierzu eine Analoganzeige mit größerer Auflösung zu erreichen.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Geht man davon aus, daß bei komfortableren Meßgeräten ohnehin zwei Ziffernanzeigen benötigt werden, so gelingt es mit Hilfe der Erfindung ohne zusätzlichen Aufwand eine Analoganzeige zu realisieren, die eine qualitativ bessere Ablesung ermöglicht. Weiterhin kann eine Aufteilung der Analoganzeige in einen Plus/Minus-Bereich erfolgen. Dient die Analoganzeige zur Darstellung einer Regelabweichung, so würde nur dann eines der waagrechten Segmente angesteuert, wenn die Regelabweichung den Wert Null unter- oder überschreitet.

Eine zweckmäßige Weiterbildung des Erfindungsgegenstandes sieht vor, daß bei einem mehrkanaligen Meßgerät, vorzugsweise einem mehrkanaligen Regler, mehrere oder alle der übereinanderliegenden 7-Segment-Anzeigen quasi analoge Anzeigen bilden. Dabei wird jeder quasi analogen Anzeigen ein getrennter Meßkanal zugeordnet.

Eine Regelabweichung mit dem Wert Null dadurch zu kennzeichnen, daß keines der waagrechten Segmente angesteuert wird, birgt die Gefahr, daß bei einem Defekt der Analoganzeige ein falscher Zustand vorgetäuscht wird. Eine Weiterbildung des Erfindungsgegenstandes sieht deshalb vor, daß zwischen je zwei übereinanderliegenden 7-Segment-Anzeigen ein zusätzliches Segment so angeordnet wird, daß es mit den waagrechten Segmenten der 7-Segment-Anzeigen auf einer Linie liegt. Dabei haben alle Segmente zueinander etwa den gleichen Abstand und das zusätzliche Segment kann die Null-Lage bei der quasi analogen Anzeige kennzeichnen. Hierdurch ist es möglich auch die Regelabweichung Null eindeutig sichtbar zu machen. Bildet man das zusätzliche Segment so aus, daß es sich von den übrigen Segmenten in seiner Farbe, seiner Form oder seinen Abmessungen unterscheidet, so wird der eingeschwungene Zustand bei einer Regelabweichung Null noch besonders hervorgehoben.

Zur Anzeige eines Plus/Minus-Bereiches ist es allerdings nicht zwingend erforderlich den Nullpunkt in Skalenmitte zu legen. Bei einem Nullpunkt am Skalenanfang läßt sich die Auflösung der Skala verdoppeln und die Polarität kann dann durch andere Mittel, z.B. durch Blinken eines Segments signalisiert werden.

Sollen mehrere Kanäle gleichzeitig, z.B. bezüglich ihrer Regelabweichung überwacht werden, so ist es zweckmäßig die hierfür erforderlichen Analoganzeigen durch die waagrechten Segmente der einzelnen nebeneinanderliegenden 7-Segment-Anzeigen zu realisieren. Will man jedoch von nur einem Meßkanal gleichzeitig einen Meßwert in Ziffern darstellen und denselben oder einen anderen Meßwert auch auf einer analogen Anzeige überwachen, so ist es zumindest bei mehrstelligen 7-Segment-Anzeigen von Vorteil die Analoganzeige mit den senkrechten Segmenten einer der beiden 7-Segment-Reihen zu realisieren.

Da eine 7-Segment-Anzeie jeweils beidseitig zwei aufeinanderstehende senkrechte Segmente besitzt, kann man diese beiden senkrechten Segmente entweder gemeinsam oder getrennt ansteuern. Bei getrennter Ansteuerung ist es möglich zwei Teilskalen zu realisieren, wobei eine Teilskala von den unteren senkrechten Segmenten und die andere Teilskala von den oberen senkrechten Segmenten der 7-Segment-Reihe gebildet wird. Den Nullpunkt für diese beiden Teilskalen könnte man an das linke oder rechte Ende der 7-Segment-Reihe legen, so daß auch ein Plus/Minus-Wechsel mit relativ hoher Auflösung sichtbar wird.

Bei der auf der Analoganzeige vorzugsweise dargestellten Regelabweichung handelt es sich ohnehin um einen Differrenzwert zwischen dem Ist- und dem Soll-Wert des Reglers. Soll z.B. ein bestimmter Meßwert, der gleichzeitig in Ziffern angezeigt wird, auch quasi analog dargestellt werden, so ist es zweckmäßig diesen nur in seinem Änderungsbereich zu erfassen, also einen bestimmten Grundwert zu unterdrücken.

Durch die erfindungsgemäße Vereinigung der beiden 7-Segment-Reihen auf einem Display ist es möglich, verschiedene Meßgrößen und Meßkanäle umzuschalten und nach Bedarf so zu kombinieren, daß nur Ziffern angezeigt werden, oder nur Analoganzeigen entstehen oder eine Kombination zwischen Analog- und Ziffernanzeige erfolgt.

Die Erfindung wird im folgenden anhand der in den Zeichnungen dargestellten Ausführungsbeispiele näher erläutert.

Es zeigen:

Fig. 1    Ein Display mit zwei 7-Segment-Reihen zur gemeinsamen Darstellung von Analoganzeigen für mehrere Kanäle,

Fig.2    ein der Fig. 1 entsprechendes Display mit zwischen den 7-Segment-Anzeigen eingefügten zusätzlichen Segmenten,

Fig. 3    die Kombination von einer quasi analogen Anzeige für mehrere Kanäle und einer Ziffernanzeige für einen Kanal,

Fig.4    die Kombination einer Analoganzeige für einen Kanal und einer Ziffernanzeige für einen Kanal,

Fig.5    ein Blockschaltbild des Meßgerätes, zu dem das Display gehört.

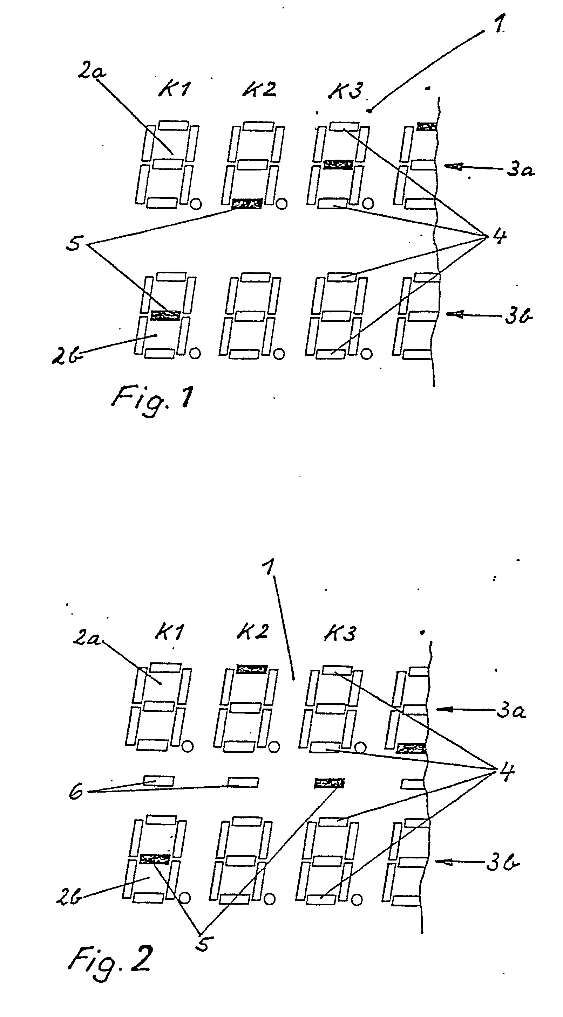

Wie Fig.1 erkennen läßt, sind auf einem Display 1 zwei aus mehreren 7-Segment-Anzeigen 2 bestehende Segmentreihen 3a,3b angeordnet. Von ihrem Grundkonzept her sind die 7-Segment-Anzeigen zur Darstellung von Ziffern vorgesehen, so daß mit Hilfe jeder der beiden 7-Segment-Reihen 3 je ein Meßwert in Ziffern dargestellt werden kann. Im vorliegenden Beispiel ist jedoch ein Fall demonstriert, bei dem die 7-Segment-Reihen gemeinsam zur Darstellung von quasi analogen Anzeigen dienen. Dazu sind die beiden 7-Segment-Reihen 3a,3b auf dem Display 1 so angeordnet, daß jeweils zwei 7-Segment-Anzeigen 2a,2b auf einer Linie praktisch senkrecht übereinander liegen und die waagrechten Segmente 4 der beiden 7-Segment-Anzeigen 2a,2b sechs Positionen einer quasi analogen Meßskala bilden.

Bei mehrkanaligen Meßgeräten kann man jedem Kanal K eine quasi analoge Anzeige 5 zuordnen. Das gilt allderdings nur, wenn die Zahl der Kanäle nicht die Zahl der 7-Segment-Anzeigen pro 7-Segment-Reihe übersteigt.

Fig.2 zeigt ein der Fig.1 entsprechendes Display, bei dem ebenfalls Meßwerte aus verschiedenen Meßkanälen K mit einer quasi analogen Anzeige 5 dargestellt sind. Eine Verbesserung sieht jedoch vor, daß zwischen zwei 7-Segment-Anzeigen 2 je ein zusätzliches Segment 6 eingefügt ist, das zu den übrigen waagrechten Segmenten 4 den gleichen Abstand hält und durch seine Postion vorzugsweise die Null-Lage der quasi analogen Skala festlegt. Ausgehend von diesem zusätzlichen Segment 6 ist somit eine Plus/Minus-Anzeige möglich. Durch eine besondere Hervorhebung des zusätzlichen Segmentes 6 z.B. mit Hilfe einer andersartigen Farbe, vorzugsweise grün, läßt sich der Eindruck verstärken, daß alles in Ordnung ist, wenn z.B. die Regelabweichung bei Null liegt.

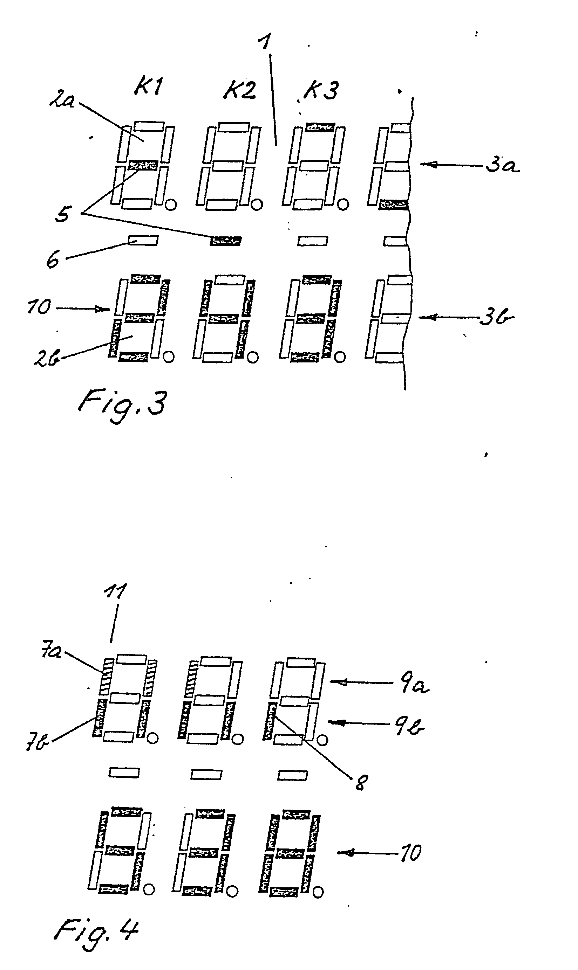

Fig.3 demonstriert einen Fall, bei dem eine quasi analoge Anzeige mit einer Ziffernanzeige kombiniert ist. Während die obere 7-Segment-Reihe 3a zur Quasi analogen Anzeige für mehrere Kanäle K dient, wird mit der unteren 7-Segment-Reihe eine mehrstellige Ziffer angezeigt. Hierdurch ist es z.B. möglich, die Regelabweichung mehrerer Kanäle zu überwachen und die kritische Regelabweichung eines bestimmten Kanals gleichzeitig in Ziffern anzuzeigen.

Eine andersartige Kombination einer Ziffernanzeige 10 und einer quasi analogen Anzeige 8 ist mit Hilfe der senkrechten Segmente 7, die beidseitig der 7-Segment-Anzeigen 2 angeordnet sind, möglich. Steuert man die an jeder 7-Segment-Anzeige übereinanderliegenden senkrechten Segmente 7a,7b getrennt an, so kann man damit zwei Teilskalen 9a, 9b realisieren, die eine entsprechend höhere Auflösung der quasi analogen Anzeige erlauben. Im vorliegenden Fall werden alle relevanten senkrechten Segmente quasi als Balken angesteuert, um die Anzeige zu verdeutlichen. Sieht man für einen Wechsel vom Plus- in den Minusbereich bei den beiden Teilskalen 9a,9b eine gemeinsame Null-Lage 11 vor, die z.B. an einem Ende einer 7-Segment-Reihe liegen kann, so kann ein Wechsel der Polarität gut beobachtet werde. Sind die beiden senkrechten Segmente 7a,7b angesteuert, so hat die Regelabweichung ihren Wert Null erreicht. Bei einem Wechsel der Polarität kämen die schraffierten senkrechten Segmente 7a zur Ansteuerung.

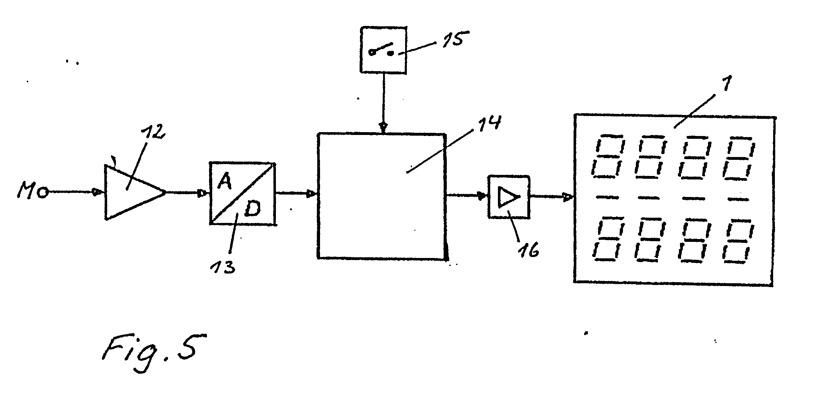

In Fig.5 ist das Blockschaltbild eines Meßgerätes dargestellt, an dessen Ausgang das erfindungsgemäße Display angeordnet ist. Der Istwert einer Meßgröße M liegt an einem Vorverstärker, der ihn über einen A/D-Wandler 13 an eine Prozessoreinheit 14 weitergibt. Mit Hilfe einer Tastatur 15 ist es möglich einen Sollwert vorzugeben, so daß innerhalb der Prozessoreinheit 14 ein Soll/Ist-Wert-Vergleich erfolgen kann. Von der Prozessoreinheit 14 aus werden die verschiedenen Meßwerte dem Display 1 über einer Treiberstufe 16 zugeführt.

**Ansprüche**

1. Display zur Darstellung von Meßwerten mit 7-Segment-Anzeigen, bei denen die Ansteuerung der einzelnen Segmente umschaltbar ist zwischen einer Segmentkombination, die zur Ziffernanzeige eines digitalen Meßwertes dient und einer Segmentkombination, bei der bestimmte, auf einer gemeinsamen Linie liegende Segmente eine quasi analoge Anzeige ermöglichen, letztere vorzugsweise zur Darstellung von Regelabweichungen, dadurch gekennzeichnet, daß auf dem Display (1) mindestens zwei zueinander parallel liegende, aus mehreren 7-Segment-Anzeigen (2) gebildete 7-Segment-Reihen (3) angeordnet sind und von diesen mindestens zwei 7-Segment-Anzeigen (2a,2b) auf einer Linie übereinander liegen und gleiche Abmessungen besitzen und die waagrecht angeordneten Segmente (4) der beiden übereinanderliegenden 7-Segment-Anzeigen (2a,2b) durch ihre Ansteuerung so miteinander verbunden sind, daß sie gemeinsam eine quasi analoge Anzeige (5) bilden.

2. Display nach Anspruch 1, dadurch gekennzeichnet, daß mehrere oder alle der übereinanderliegenden 7-Segment-Anzeigen (2) quasi analoge Anzeigen (5) bilden, wobei jeder quasi analogen Anzeige (5) ein getrennter Meßkanal zugeordnet ist.

3. Display nach einem der vorhergehenden Ansprüche, dadurch gekennzeichnet, daß zwischen je zwei übereinanderliegenden 7-Segment-Anzeigen (2) ein zusätzliches Segment (6) so angeordnet ist, daß es mit den waagrechten Segmenten (4) der 7-Segment-Anzeige (2) auf einer Linie liegt, wobei alle Segmente (4,6) zueinander etwa gleichen Abstand haben und daß zusätzliche Segment (6) die Null-Lage bei der quasi analogen Anzeige (5) kennzeichnet.

4. Display nach einem der vorhergehenden Ansprüche, dadurch gekennzeichnet, daß die zusätzlichen Segmente (6) sich von den übrigen Segmenten (4) in ihrer Farbe, ihrer Form oder ihren Abmessungen unterscheiden.

5. Display nach einem der vorhergehenden Ansprüche, dadurch gekennzeichnet, daß quasi analoge Anzeigen (5) mit Nullpunkt am Skalenanfang gebildet sind und die Polarität durch eine zusätzliche Anzeige, ggf. durch Blinken des zusätzlichen Segmente (6) signalisiert ist.

6. Display nach einem der vorhergehenden Ansprüche, dadurch gekennzeichnet, daß senkrecht auf einer Linie nebeneinanderliegende Segmente (7) einer 7-Segment-Reihe (3) so angesteuert sind, daß sie eine quasi analoge Anzeige (8) ermöglichen.

7. Display nach einem der vorhergehenden Ansprüche, dadurch gekennzeichnet, daß jeweils die beiden übereinander angeordneten, eine Seite einer Ziffer bildenden senkrechten Segmente (7a,7b) gemeinsam angesteuert sind und gemeinsam eine Anzeigeposition bilden.

8. Display nach einem der Ansprüche 1 bis 6, dadurch gekennzeichnet, daß jeweils die beiden übereinander angeordneten, eine Seite einer Ziffer bildenden senkrechten Segmente (7a,7b) getrennt angesteuert sind und zwei parallel liegenden Teilskalen entsprechen.

9. Display nach einem der vorhergehenden Ansprüche außer Anspruch 7, dadurch gekennzeichnet, daß eine Teilskala (9a) zur Anzeige positiver und die andere Teilskala (9b) zur Anzeige negativer Werte dient und der Nullpunkt am linken oder rechten Ende der Teilskalen liegt.

10. Display nach einem der vorhergehenden Ansprüche, dadurch gekennzeichnet, daß die durch Segmente einer der beiden 7-Segment-Reihen (3) dargestellte quasi analoge Anzeige (5,8) nur einen Bruchteil des Meßumfangs erfaßt, der durch die Segmente der jeweils anderen 7-Segment-Reihe (36) in Ziffern (10) darstellbar ist, so daß vorzugsweise nur die Änderung des Meßwertes quasi analog zur Anzeige kommt.

11. Display nach einem der vorhergehenden Ansprüche, dadurch gekennzeichnet, daß die Ansteuerung der Segmente der beiden 7-Segment-Reihen so umschaltbar ist, daß diese beide Ziffernanzeigen (10) oder beide quasi analoge Anzeigen (5,8) bilden oder die eine zur Analoganzeige (5,8) und die andere zur Ziffernanzeige (10) dient, wobei auf der Ziffernanzeige (10) vorzugsweise der Sollwert und/oder der Istwert und/oder die Regelabweichung darstellbar sind, während auf der quasi analogen Anzeige (5,8) vorzugsweise die Regelabweichung darstellbar ist, die bei einer kombinierten Anzeige sowohl in Ziffern als auch quasi analog darstellbar ist.

12. Display nach einem der vorhergehenden Ansprüche, dadurch gekennzeichnet, daß bei mehreren Meßkanälen diese wahlweise auf das Display (1) schaltbar sind, soweit die Anzeigen (5,8,10) nicht die Wiedergabe der Werte aller Kanäle ermöglichen.

## Claims

1. Display for representing measured values with 7-segment displays, in which the actuation of the individual segments can be switched between a segment combination which serves for displaying digits of a digital measured value and a segment combination in which certain segments lying on a common line permit a quasi-analog display, the latter preferably for representing standard tolerances, characterised in that at least two 7-segment rows (3) lying parallel to one another and formed from a plurality of 7-segment displays (2) are arranged on the display (1), and of the said segment rows at least two 7-segment displays (2a, 2b) lie one above the other on a line and have the same dimensions, and the horizontally arranged segments (4) of the two 7-segment displays (2a, 2b) lying one above the other are connected to one another by their actuation in such a way that they form together a quasi-analog display (5).

2. Display according to Claim 1, characterised in that a plurality of or all of the 7-segment displays (2) lying one above the other form quasi-analog displays (5), each quasi-analog display (5) being assigned a separate measuring channel.

3. Display according to one of the preceding claims, characterised in that an additional segment (6) is arranged between each two 7-segment displays (2) lying one above the other in such a way that it lies on a line with the horizontal segments (4) of the 7-segment displays (2), all the segments (4, 6) having approximately the same spacing relative to one another and the additional segment (6) characterising the zero position on the quasi-analog display (5).

4. Display according to one of the preceding claims, characterised in that the additional segments (6) differ from the other segments (4) in their colour, their shape or their dimensions.

5. Display according to one of the preceding claims, characterised in that quasi-analog displays (5) are formed with the zero point at the beginning of the scale and the polarity is indicated by an additional display, possibly by the flashing of the additional segment (6).

6. Display according to one of the preceding claims, characterised in that segments (7) of a 7-segment row (3) lying vertically next to one another on a line are actuated in such a way that they permit a quasi-analog display (8).

7. Display according to one of the preceding claims, characterised in that in each case the two segments (7a, 7b) arranged one above the other and forming one side of a digit are actuated together and form a display position together.

8. Display according to one of Claims 1 to 6, characterised in that in each case the two vertical segments (7a, 7b) arranged one above the other and forming one side of a digit are actuated separately and correspond to two parallel sub-scales.

9. Display according to one of the preceding claims, apart from Claim 7, characterised in that one sub-scale (9a) serves for displaying positive values and the other sub-scale (9b) for displaying negative values and the zero point is at the left or right hand end of the sub-scales.

10. Display according to one of the preceding claims, characterised in that the quasi-analog display (5, 8) represented by segments of one of the two 7-segment rows (3) only covers a fraction of the measuring range which can be represented by the segments of the respective other 7-segment row (36) in digits (10), so that preferably only the change of the measured value is displayed in a quasi-analog fashion.

11. Display according to one of the preceding claims, characterised in that the actuation of the segments of the two 7-segment rows can be switched over in such a way that they both form digit displays (10) or both form quasi-analog displays (5, 8) or the one serves as an analog display (5, 8) and the other as a digit display (10), it being preferably possible to represent the desired value and/or the actual value and/or the standard tolerance on the digit display (10) whilst preferably the standard tolerance can be represented on the quasi-analog display (5, 8), it being possible to represent said standard tolerance on a combined display both in digits and in a quasi-analog fashion.

12. Display according to one of the preceding claims, characterised in that with a plurality of measuring channels the said channels can be connected selectively to the display (1) if the displays (5, 8, 10) do not permit the values of all the channels to be reproduced.

**Revendications**

1. Dispositif d'affichage pour l'indication de valeurs de mesure, comprenant des éléments d'affichage à 7 segments, dans les-quels le système d'activation des différents segments peut être commuté entre une combinaison de segments servant à l'affichage, sous forme de chiffres, d'une valeur de mesure numérique et une combinaison de segments dans laquelle certains segments situés sur une ligne commune permettent un affichage quasi-analogique qui sert de préférence à indiquer des déviations, caractérisé par le fait que sur le dispositif d'affichage (1) au moins deux rangées (3) à 7 segments, constitués de plusieurs éléments (2) à 7 segments, sont disposées parallèlement l'une à l'autre, et au moins deux éléments d'affichage (2a, 2b) à 7 segments sont alignés l'un au-dessus de l'autre et présentent les mêmes dimensions, et les segments (4) horizontaux des deux éléments d'affichage (2a, 2b) à 7 segments, disposés l'un au-dessus de l'autre, sont reliés par leur système de commande d'une manière telle qu'ils forment un affichage quasi-analogique (5).

2. Dispositif d'affichage selon la revendication 1, caractérisé par le fait que plusieurs ou tous les éléments d'affichage (2) à 7 segments forment des affichages quasi-analogiques (5), un canal de mesure séparé étant associé à chaque affichage quasi-analogique (5).

3. Dispositif d'affichage selon l'une des revendications précédentes, caractérisé par le fait qu'entre chaque fois deux éléments d'affichage (2) à 7 segments, disposés l'un au-dessus de l'autre, un segment (6) supplémentaire est disposé de manière telle qu'il soit aligné avec les segments (4) horizontaux des éléments d'affichage (2) à 7 segments, tous les segments (4, 6) ayant la même distance les uns par rapport aux autres et le segment (6) supplémentaire signalant la position zéro de l'affichage quasi-analogique (5).

4. Dispositif d'affichage selon l'une des revendications précédentes, caractérisé par le fait que les segments (6) supplémentaires diffèrent des autres segments (4) par leur couleur, leur forme ou leurs dimensions.

5. Dispositif d'affichage selon l'une des revendications précédentes, caractérisé par le fait que des affichages quasi-analogiques (5) sont formés avec leur point zéro situé au début de la graduation, et la polarité est signalée par un affichage supplémentaire, le cas échéant par le clignotement du segment (6) supplémentaire.

6. Dispositif d'affichage selon l'une des revendications précédentes, caractérisé par le fait que des segments (7), disposés perpendiculairement les uns à côté des autres sur une ligne, d'une rangée (3) à 7 segments sont activés de manière telle qu'ils permettent un affichage quasi-analogique (8).

7. Dispositif d'affichage selon l'une des revendications précédentes, caractérisé par le fait que chaque fois les deux segments perpendiculaires (7a, 7b) disposés l'un au-dessus de l'autre et formant un côté d'un chiffre sont activés ensemble et forment ensemble une position d'affichage.

8. Dispositif d'affichage selon l'une des revendications 1 à 6, caractérisé par le fait que chaque fois les deux segments perpendiculaires (7a, 7b) disposés l'un au-dessus de l'autre et formant un côté d'un chiffre sont activés séparément et correspondent à deux graduations partielles parallèles l'une à l'autre.

9. Dispositif d'affichage selon l'une des revendications précédentes sauf la revendication 7, caractérisé par le fait qu'une graduation partielle (9a) sert à l'affichage de valeurs positives et l'autre graduation partielle (9b) sert à l'affichage de valeurs négatives, et le point zéro se situe à l'extrémité gauche ou droite des graduations partielles.

10. Dispositif d'affichage selon l'une des revendications précédentes, caractérisé par le fait que l'affichage quasi-analogique (5, 8) indiqué par des segments de l'une des deux rangées (3) à 7 segments ne couvre qu'une fraction de l'étendue de mesure qui peut être indiquée sous forme de chiffres (10) par les segments de l'autre rangée (36) à 7 segments, de manière à ce que de préférence seule la variation de la valeur de mesure soit affichée sous une forme quasi-analogique.

11. Dispositif d'affichage selon l'une des revendications précédentes, caractérisé par le fait que le système d'activation des segments des deux rangées à 7 segments peut être commuté de manière telle que ces rangées forment toutes les deux, soit des affichages numériques (10), soit des affichages quasi-analogiques (5, 8) ou bien que l'une des rangées serve à l'affichage analogique (5, 8) et l'autre à l'affichage numérique (10), l'affichage numérique (10) indiquant de préférence la valeur de consigne et/ou la valeur réelle et/ou la déviation, tandis que l'affichage quasi-analogique (5, 8) permet de préférence d'indiquer la déviation qui, dans un système d'affichage combiné, peut aussi bien être indiquée sous une forme numérique que sous une forme quasi-analogique.

12. Dispositif d'affichage selon l'une des revendications précédentes, caractérisé par le fait que dans le cas de plusieurs canaux de mesure, ceux-ci peuvent être connectés de manière sélective au dispositif d'affichage (1), dans la mesure où les affichages (5, 8, 10) ne permettent pas d'indiquer les valeurs de tous les canaux.

Fig. 1

Fig. 2

Fig.3

Fig.4

Fig. 5